# FASCICULE DE BREVET EUROPEEN

(11) **EP 3 117 465 B1**
(45) Date de publication et mention de la délivrance du brevet: **20.07.2022**
(21) Numéro de dépôt: 15717017.6
(22) Date de dépôt: 10.03.2015
(51) Int. Cl.: H01L 29/778, H01L 21/338, H01L 29/207, H01L 29/08, H01L 29/20

(54) **TRANSISTOR A EFFET DE CHAMP ET A HETEROJONCTION.**
FELDEFFEKTTRANSISTOR MIT HETEROÜBERGANG
HETEROJUNCTION FIELD-EFFECT TRANSISTOR

(30) Priorité: 14.03.2014 FR 1452132
(43) Date de publication de la demande: 18.01.2017
(73) Titulaire: OMMIC, 94450 Limeil-Brévannes (FR)
(72) Inventeur: FRIJLINK, Peter, F-91330 Yerres (FR)
(74) Mandataire: Fédit-Loriot
(86) Numéro de dépôt international: PCT/FR2015/050600
(87) Numéro de publication internationale: WO 2015/136218

(56) Documents cités:
- US-A1- 2005 258 451
- US-A1- 2008 176 366
- SUZUKI ASAMIRA ET AL: "Extremely low on-resistance enhancement-mode GaN-based HFET using Ge-doped regrowth technique", 2014 IEEE INTERNATIONAL ELECTRON DEVICES MEETING, IEEE, 15 December 2014 (2014-12-15), XP032737981, DOI: 10.1109/IEDM.2014.7047029 [retrieved on 2015-02-20]

## Description

L'invention concerne un transistor à effet de champ et à hétérojonction ou HEMT (de l'anglais « High Electronic Mobility Transistor »), comprenant une structure semiconductrice en couches superposées déposées sur un substrat, les couches superposées étant composées de matériaux semiconducteurs à cristal hexagonal de type Ga_{(1-p-q)}Al₍ₚ₎In_{(q)}N, où p et q peuvent être compris entre 0 inclus et 1 inclus, la somme p+q étant inférieure ou égale à 1, et le doublet {p,q} étant spécifique à chaque couche. Le matériau du substrat peut être par exemple du GaN, de l'AlN, du SiC, du Si, du diamant ou du saphir.

Ce transistor pourra être utilisé dans un MMIC (de l'anglais « Monolithic Microwave Integrated Circuit »), ou dans un autre circuit.

Un transistor HEMT (dit aussi HFET, de l'anglais « Heterostructure Field Effect Transistor » ou MODFET, de l'anglais « Modulation Doped Field Effect Transistor ») comprend typiquement:
- une couche canal, réalisée en un premier matériau semiconducteur, par exemple GaN,
- une couche barrière sur la couche canal, réalisée dans un matériau semiconducteur avec un gap plus grand que le premier matériau, et une affinité électronique plus petite que le premier matériau, par exemple AlN ou AlGaN,
- une électrode de grille formant avec la couche barrière une jonction Schottky, et
- une électrode de source et une électrode de drain de part et d'autre de l'électrode de grille.

Il est connu de déposer aux emplacements correspondants aux électrodes de source et de drain, avant le dépôt de ces électrodes, une couche de GaN dopée avec des atomes de Si par croissance épitaxiale. Cette couche de GaN dopée peut permettre de concevoir des transistors avec des dimensions plus faibles. Pour délimiter ces emplacements, on utilise une couche de masquage.

Les documents K.Shinohara et al, « Electron Velocity Enhancement in laterraly Scaled GaN DH-HEMTs with fT of 260 GHz », IEEE Electron Device Letters, Vol. 32, No 8, Août 2011 et T.Fujiwara, « Low Ohmic Contact résistance m-Plane AlGaN/GaN Heterojunction Field-Effect Transistors with Enhancement-Mode Operations », Applied Physics Express 3 (2010) décrivent deux exemples de procédés de fabrication de transistors HEMT sur substrat GaN, avec des étapes de croissance épitaxiales localisées de couches dopées au Silicium.

Le document A. Suzuki et al., « Extremely low on-resistance enhancement-mode GaN-based HFET using Ge-doped regrowth technique », 2014 IEEE International electron devices meeting, 15-12-2014, montre un transistor HFET avec des régions de GaN dopées au germanium pour contacts ohmiques et formées par croissance sélective.

Le document US 2005/0258451, cité dans le rapport de recherche préliminaire établi pour la demande française dont la priorité est ici revendiquée, décrit un transistor HEMT obtenu en déposant la couche de GaN dopé au Silicium, au Germanium, à l'Oxygène, ou autre, à température suffisamment basse pour empêcher le transport de masse vers les emplacements correspondant aux électrodes de drain et source. Même si le choix d'un dopage au Germanium est mentionné parmi autres possibilités, ce choix d'une température basse est effectué pour éviter les inconvénients liés au transport de masse dans le cas d'un dépôt par épitaxie de GaN dopé au Silicium, à savoir un risque d'accidents de morphologie, notamment des précipités SiN, des hauteurs de couches de GaN peu uniformes et une reproductibilité médiocre. Du fait de l'absence de transport de masse, le GaN est déposé avec une épaisseur relativement faible afin d'éviter de dépasser la couche de diélectrique.

Il existe un besoin pour un procédé relativement simple permettant une meilleure définition des bords des couches d'épitaxie localisées.

Il est proposé un procédé de fabrication d'un transistor à effet de champ et à hétérojonction comprenant une structure semiconductrice en couches superposées , le procédé comprenant :
a) prévoir sur un substrat
   une couche tampon composée d'un matériau semiconducteur à cristal hexagonal Ga_{(1-x-y)}Al₍ₓ₎In_{(y)}N, où x et y sont compris entre 0 inclus et 1 inclus, la somme x+y étant inférieure ou égale à 1,
   une couche canal sur la couche tampon, cette couche canal étant composée d'un matériau à cristal hexagonal Ga_{(1-z-w})Al_{(z)}In_{(w)}N, où z et w sont compris entre 0 inclus et 1 inclus, la somme z+w étant inférieure ou égale à 1, l'un au moins parmi z et w étant différent de x ou y, respectivement,
   une couche barrière sur cette couche canal, cette couche barrière étant composée d'un matériau à cristal hexagonal Ga_{(1-z'-w')}Al_{(z')}In_{(w')}N, où z' et w' sont compris entre 0 inclus et 1 inclus, la somme z'+w' étant inférieure ou égale à 1, l'un au moins parmi z' et w' étant différent de z ou w, respectivement,
b) déposer une couche de masquage en un matériau diélectrique sur la couche barrière,
c) former une ouverture dans la couche de masquage, et allonger cette ouverture de sorte que la couche barrière présente une épaisseur réduite ou nulle à l'emplacement de l'ouverture,
d) faire croître par épitaxie à haute température un matériau semiconducteur à cristal hexagonal Ga_{(1-x'-y'})Al_{(x')}In_{(y')}N dopé au Germanium, où x' et y' sont compris entre 0 inclus et 1 inclus, la somme x'+y' étant inférieure ou égale à 1, sur une zone de croissance correspondant à l'emplacement de l'ouverture formée dans la couche de masquage, cette étape étant réalisée tel que décrit dans la revendication 1,
e) déposer une électrode de contact, source ou drain, sur le matériau déposé par épitaxie à l'étape d),
f) déposer une électrode de grille à un emplacement en dehors de la zone de croissance.

Par « haute température », on entend une température suffisamment élevée pour que le matériau semiconducteur à cristal hexagonal Ga_{(1-x'-y'})Al_{(x')}In_{(y')}N dopé au Germanium puise migrer vers la zone de croissance, par transport de masse, de sorte que l'étape d) est sélective. Cette température est comprise entre 700° et 1200°C, avantageusement strictement supérieure à 960°C et inférieure ou égale à 1150°C, avantageusement entre 970°C et 1150°C.

Ce procédé peut permettre d'obtenir des bords de la couche de matériau déposé par épitaxie plus francs que dans l'art antérieur, ce qui peut être intéressant dans la mesure où ces bords peuvent servir de repère d'alignement lors d'étapes supplémentaires du procédé de fabrication.

Ce procédé peut ainsi permettre l'alignement précis de la grille à proximité du contact ohmique de source et/ou du contact ohmique de drain, ce qui permet d'obtenir des résistances série plus faibles, et d'améliorer le gain des transistors.

Il a été observé qu'en appliquant ce procédé, on obtenait un produit dans lequel le matériau dopé au Germanium avait une structure cristalline suffisamment définie pour que les bords latéraux de la couche de croissance ainsi obtenue soient légèrement inclinés, et donc relativement distants des bords sensiblement verticaux de la couche de masquage. Ainsi, ce procédé peut permettre d'éviter d'avoir à protéger la couche de masquage diélectrique par un autre masque avant l'étape d), et d'éviter l'étape de retrait de ce masque après l'étape d), comme décrit dans le document US 2005/0258451.

En outre, avec le procédé décrit ci-dessus, le matériau de croissance peut être déposé de façon à former une couche de croissance relativement épaisse, et notamment plus épaisse que la couche de masquage, et ce sans risquer de rendre le procédé plus long ou plus complexe. Ainsi, la couche de masquage peut avoir une épaisseur relativement faible, par exemple entre 0,1 et 100 nm, avantageusement entre 0,5 et 10 nm, avantageusement entre 1 et 7 nm, par exemple 5 nm.

Ce procédé permet ainsi de produire un transistor à effet de champ et à hétérojonction comprenant une structure semiconductrice en couches superposées , les couches semiconductrices étant composées essentiellement de matériaux III-V, les atomes de la colonne V de la classification périodique étant des atomes d'azote, et les atomes de la colonne III de cette classification étant choisis parmi le Gallium, l'Aluminium et l'Indium.

Le matériau du substrat peut être par exemple du GaN, de l'AlN, du SiC, du Si, du diamant, du saphir, ou autre.

L'un au moins parmi x' et y' peut être différent de z' ou w', respectivement, c'est-à-dire que x' a une valeur différente de z' et/ou que y' a une valeur différente de w'. Dit autrement, le matériau de la couche de croissance peut être différent du matériau de la couche barrière.

Le matériau de la couche canal est différent du matériau de la couche tampon, c'est-à-dire que z a une valeur différente de x et/ou w a une valeur différente de y.

Le matériau de la couche barrière est différent du matériau de la couche canal, c'est-à-dire que z' a une valeur différente de z et/ou w' a une valeur différente de w.

En outre, les matériaux des couches barrière et canal sont choisis de façon à permettre la fabrication d'un transistor HEMT. Le gap du matériau de la couche barrière est plus grand que le gap du matériau de la couche canal, et l'affinité électronique du matériau de la couche barrière est plus petite que celle du matériau de la couche canal, de sorte qu'il se forme un gaz bidimensionnel d'électrons dans la couche canal. Les matériaux des couches canal et barrière sont ainsi choisis de façon à provoquer une accumulation d'électrons à l'interface entre ces deux couches. L'électrode de grille peut alors former avec cette couche barrière une jonction Schottky.

Les matériaux des couches tampon, canal et barrière peuvent être non dopés, ou bien être dopés.

La structure peut comprendre une ou plusieurs couches tampon, c'est-à-dire que, de façon connue en soi, l'épaisseur tampon peut être multicouches. De la même façon, la structure peut comprendre une ou plusieurs couches canal, une ou plusieurs couches barrière.

Par « dopé au Germanium », on entend que le matériau épitaxial comprend un nombre d'atomes de Germanium par centimètre cube supérieur ou égal à 10¹⁸.

Avantageusement et de façon non limitative, la couche de masquage peut être retirée, sur la totalité de l'emplacement correspondant à cette couche, ou bien sur une partie seulement de cet emplacement. Cette étape de retrait peut intervenir après l'étape d) de croissance et avant le dépôt de l'électrode de grille.

A l'étape c), l'ouverture dans la couche de masquage peut être formée en retirant par gravure du matériau de la couche de masquage.

Selon l'invention, on allonge cette ouverture de sorte que la couche barrière présente une épaisseur réduite à l'emplacement de l'ouverture, ou nulle. Dans ce dernier cas, la partie de la couche barrière correspondant à cet emplacement est supprimée.

Avantageusement et de façon non limitative, le procédé peut comprendre une étape de gravure, préalable à l'étape d) de croissance épitaxiale, pour retirer du matériau à l'emplacement de l'ouverture formée dans la couche de masquage, de façon à supprimer la partie de la couche barrière correspondant à cet emplacement.

Cette suppression locale de la couche barrière évite aux électrons qui forment le courant source-drain de devoir franchir la barrière de potentiel correspondant à la couche barrière, diminuant ainsi fortement la tension Vds entre drain et source nécessaire pour faire circuler un courant source-drain, en cas de polarisation maximale positive de la grille par rapport à la source. Ceci diminue la dissipation de chaleur dans le transistor lors de son utilisation, et augmente donc l'efficacité en puissance d'amplificateurs comprenant de tels transistors. Le fait de ne pas devoir faire franchir la couche barrière permet aussi de choisir une couche barrière qui est optimisée pour donner un relativement faible courant de fuite de Schottky en inverse, et une relativement forte polarisation électrostatique même si l'épaisseur de la couche barrière est relativement faible, par exemple de l'ordre de 1-10 nm, par exemple 4 nm. De fait de cette faible épaisseur, la transconductance intrinsèque est relativement élevée, de sorte que la fréquence de coupure du transistor peut être relativement élevée. Du fait de la forte polarisation électrostatique, la concentration d'électrons dans la couche canal est relativement élevée, ce qui permet un relativement fort courant maximal du transistor par unité de largeur. Une telle couche barrière à forte barrière de potentiel et forte polarisation électrostatique peut par exemple être formée par le matériau AlN sur une couche canal en GaN, sur une couche tampon avec une maille cristalline proche du GaN.

Avantageusement, on peut prévoir d'allonger cette ouverture, par exemple par gravure, de sorte que la couche canal présente une épaisseur réduite à l'emplacement de l'ouverture, ou nulle. L'étape de gravure peut par exemple être menée de façon à allonger l'ouverture formée à l'étape c) jusqu'à la couche canal, par exemple en diminuant l'épaisseur de la couche canal à cet emplacement (c'est-à-dire que l'ouverture est définie dans la couche canal) ou bien encore en supprimant la partie de la couche canal correspondant à cet emplacement (c'est-à-dire que l'ouverture passe à travers la couche canal, pour atteindre la couche tampon ou le substrat).

Le matériau épitaxié peut être dopé uniquement au Germanium, ou bien comprendre en outre d'autres atomes assurant un dopage, par exemple des atomes de silicium, le nombre d'atomes par centimètre cube de l'ensemble de ces autres dopants étant inférieur ou égal au nombre d'atomes par centièmes cube de Germanium. Dit autrement, le Germanium représente au moins 50% en nombre des dopants, avantageusement au moins 80%, avantageusement prés de 100%.

Avantageusement et de façon non limitative, le procédé peut inclure une étape préalable d'isolation pour rendre non-conductrice une zone autour du transistor. On s'assure ainsi que lors du fonctionnement du transistor, les électrons circulant entre la source et le drain passent bien par la couche canal contrôlée par la tension de grille. Des méthodes courantes, par exemple gravure des couches actives ou implantation ionique, pourront être mises en œuvre. Ceci est habituel pour tout transistor à effet de champ, et connu de l'homme de l'art.

Avantageusement et de façon non limitative, à l'étape d) on peut prévoir de mettre en œuvre une technique d'épitaxie en phase vapeur aux organométalliques ou MOVPE (de l'anglais « metalorganic vapor phase epitaxy »), ou encore ou MOCVD (de l'anglais « metalorganic chemical vapor deposition »). Cette technique peut être relativement avantageuse en ce sens que le procédé peut être relativement facile à industrialiser.

L'invention n'est bien entendu pas limitée à un choix de technique d'épitaxie particulière pour cette étape d). On pourra par exemple prévoir de mettre en œuvre une technique d'épitaxie par jets moléculaires ou MBE (de l'anglais « Molecular Beam Epitaxy »), ou toute autre technique permettant de faire croitre par épitaxie un matériau III-V, les atomes de la colonne V de la classification périodique étant des atomes d'azote, et les atomes de la colonne III de cette classification étant choisis parmi le Gallium, l'Aluminium et l'Indium.

Avantageusement et de façon non limitative, au cours de l'étape e), on dépose plusieurs couches métalliques, par exemple :
- une couche d'accrochage, par exemple de Titane, déposée sur le matériau épitaxié,
- une couche de barrière, par exemple de Platine, déposée sur la couche d'accrochage, et
- une couche de conduction, par exemple d'Or, déposée sur la couche barrière.

Alternativement, l'électrode de contact peut être formée d'une seule couche, par exemple de Tungstène.

Avantageusement et de façon non limitative, l'étape e) de dépose de l'électrode de contact peut être effectuée sans recuit d'alliage.

Cette électrode de contact peut comprendre une électrode de source.

Au cours de cette étape, on peut prévoir de déposer en outre une électrode de drain.

Il est en outre proposé un transistor à effet de champ et à hétérojonction selon la revendication 7, comprenant une structure semiconductrice en couches superposées, comprenant dans l'ordre d'empilage sur un substrat :
- une couche tampon composée d'un matériau semiconducteur à cristal hexagonal Ga_{(1-x-y)}Al₍ₓ₎In_{(y)}N, où x et y sont compris entre 0 inclus et 1 inclus, la somme x+y étant inférieure ou égale à 1,
- une couche canal, cette couche canal étant composée d'un matériau à cristal hexagonal Ga_{(1-z-w})Al_{(z)}In_{(w)}N, où z et w sont compris entre 0 inclus et 1 inclus, la somme z+w étant inférieure ou égale à 1, z étant différent de x et/ou w étant différent de y,
- une couche barrière, cette couche barrière étant composée d'un matériau à cristal hexagonal Ga_{(1-z'-w')}Al_{(z')}In_{(w')}N, où z' et w' sont compris entre 0 inclus et 1 inclus, la somme z'+w' étant inférieure ou égale à 1, z' étant différent de z et/ou w' étant différent de w,
- une couche de matériau de croissance (dite couche épitaxiale) déposé par épitaxie à haute température sur une zone de croissance correspondant à l'emplacement d'une ouverture formée dans une couche de masquage diélectrique, ce matériau de croissance étant composé de Ga_{(1-x'-y'})Al_{(x')}In_{(y')}N dopé au Germanium et à cristal hexagonal, où x' et y' sont compris entre 0 inclus et 1 inclus, la somme x'+y' étant inférieure ou égale à 1, ce matériau épitaxial ayant une structure cristalline suffisamment définie pour que ses bords latéraux présentent une inclinaison par rapport à la verticale entre 5° et 60° à la hauteur de la couche de masquage et au-delà de celle-ci,
- une électrode de contact, source ou drain, sur la couche de matériau de croissance et une électrode de grille à un emplacement extérieur à la zone de croissance.

Ce transistor HEMT peut présenter des bords de la couche de matériau de croissance relativement nets. Selon l'invention, ces bords présentent une inclinaison par rapport à la verticale entre 5° et 60 °, typiquement aux alentours de 45°.

Il est en outre proposé un circuit intégré, comprenant un transistor telle que décrit ci-dessus.

Ce circuit peut être un circuit intégré monolithique hyperfréquences (MMIC), ou autre.

Dans la présente demande, on entend par « sur» aussi bien « directement sur» qu' « indirectement sur », c'est-à-dire qu'une couche déposée sur une autre peut être en contact avec cette autre couche, ou bien séparée de cette autre couche par une ou plusieurs couches intermédiaires.

L'invention sera mieux comprise en référence aux figures, lesquelles illustrent des modes de réalisation donnés à titre d'exemple et non limitatifs.

Les figures 1 à 5 sont des vues en coupe, et très schématiques, d'un exemple de transistor en cours de fabrication, selon un exemple de procédé selon un mode de réalisation de l'invention.

La figure 6 est une vue en coupe, et très schématique, d'un exemple de transistor selon un mode de réalisation de l'invention.

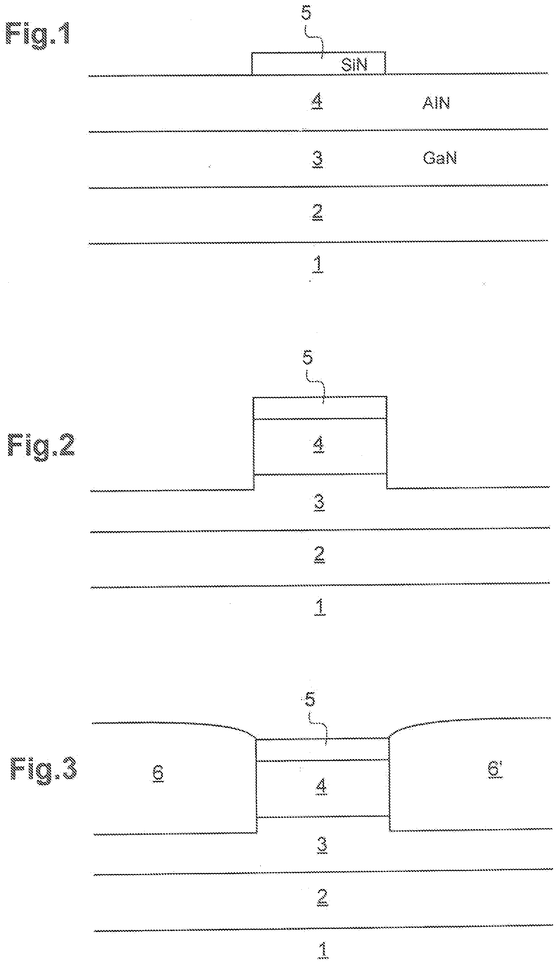

Selon l'invention, les bords latéraux du matériau épitaxial dopé au Germanium présentent une inclinaison par rapport à la verticale entre 5° et 60° à la hauteur de la couche de masquage et au-delà de celle-ci, bien que cela ne soit pas représenté sur les figures 3 à 5.

Des références identiques seront utilisées d'une figure à l'autre pour désigner des éléments identiques ou similaires.

En référence à la figure 1, on prévoit une superposition, sur un substrat 1 par exemple composé de Silicium, de couches semiconductrices à cristal hexagonal, composées de matériaux III-V, les atomes de la colonne V de la classification périodique étant des atomes d'azote, et les atomes de la colonne III de cette classification étant choisis parmi le Gallium, l'Aluminium et l'Indium.

Cette superposition comprend :
- une couche tampon 2, par exemple composée de Ga_{0,9}Al_{0,1}N non dopé,
- une couche canal 3, par exemple composée de GaN non dopé,
- une couche barrière 4, par exemple composée de AlN non dopé,
- une couche de masquage 5 diélectrique, par exemple composée de SiN.

Sur la figure 1, une étape de gravure, menée de façon connue en soi et impliquant une couche de masquage supplémentaire non représentée car retirée après la gravure, a conduit à former des ouvertures dans la couche de masquage 5, de sorte qu'il reste simplement une partie centrale de cette couche 5.

En référence à la figure 2, une étape de gravure, menée de façon connue en soi, conduit à retirer du matériau au niveau des ouvertures formées dans la couche de masquage 5, de façon à supprimer la partie de la couche barrière 4 correspondant à ces emplacements. Ainsi, seule la partie de la couche barrière 4 correspondant à l'emplacement de la partie centrale de la couche 5 est conservée. Les ouvertures ainsi définies s'étendent à présent en épaisseur jusqu'à la couche canal 3.

En référence à la figure 3, on fait croitre par une technique MOVPE du matériau de croissance dopé au Germanium 6, 6', aux emplacements correspondants aux ouvertures de la couche de masquage 5. Le matériau de croissance est à cristal hexagonal, composé de GaN dopé N+ au Germanium.

Le choix du Germanium permet d'obtenir des interfaces entre les parties 6, 6' et 5 relativement nettes.

Cette étape est effectuée à haute température, de façon à obtenir un transport de masse substantiel. Les germes peuvent par exemple être susceptibles de migrer sur des distances de l'ordre de 10 µm. Dans la mesure où la distance entre emplacements de drain et de source est en général inférieure au µm, on comprendra que la sélectivité est assurée. Le matériau des germes qui auraient pu se former sur la couche 5 est ainsi transporté par diffusion à la surface de la couche 5 vers les couches 6 et 6', où l'incorporation est thermodynamiquement plus favorable. Ce processus à haute température permet de limiter, et avantageusement d'interdire, la formation de germes à la surface de la couche 5.

Le matériau de croissance étant dopé au Germanium, les tensions mécaniques sont plus faibles qu'avec un matériau dopé Si, et on ne retrouve pas les accidents de morphologie susceptibles de se produire dans le cas d'un dopage au Silicium. L'épaisseur des couches de croissance 6, 6' est relativement uniforme sur toute la plaque. Les bords des zones 6, 6' sont relativement nets. La reproductibilité est également satisfaisante.

Un fort dopage de ces zones d'épitaxie localisée 6, 6' est avantageux car cela permet d'éviter la nécessité de l'alliage pour réaliser un bon contact ohmique à faible résistance de contact avec les électrodes, et l'amélioration et le meilleur contrôle de la morphologie permet donc de réduire encore davantage les dimensions.

Pour ce faire, les conditions suivantes pourront être mises en œuvre pour l'étape d'épitaxie localisée:
- gaz vecteur : H₂, et/ou N₂ et/ou un autre gaz inerte,
- température entre 700 et 1150°C, avantageusement entre 1000° et 1150°C,
- réactifs : Triméthylgallium (et/ou d'autres organométalliques de Ga) et NH₃ (et/ou d'autres molécules fournisseurs de N, tel que hydrazine, amines etc.),
- Gaz dopant : GeH₄ (et/ou composés organo-germanium ou halogéniures de Germanium).

Les proportions de réactifs et de dopant sont choisies de façon à obtenir un matériau présentant 10¹⁸ atomes de Germanium par centimètre cube, ou davantage, par exemple 10²⁰ ou 10²¹ atomes de Germanium par centimètre cube.

Puis on dépose, de façon connue en soi, des contacts 15, 16 sur ces couches de matériau de croissance 6, 6'. Plus précisément, chaque contact 15, 16 comprend :
- une couche d'accrochage 7, 10, par exemple une couche de Titane, déposée sur le matériau épitaxié,
- une couche de barrière 8, 11, par exemple une couche de Platine, déposée sur la couche d'accrochage correspondante 7, 10, et
- une couche de conduction 9, 12, par exemple une couche d'Or, déposée sur la couche barrière correspondante 8, 11.

On peut relever que ce dépôt des contacts de source 15 et de drain 16 est effectué sans recuit.

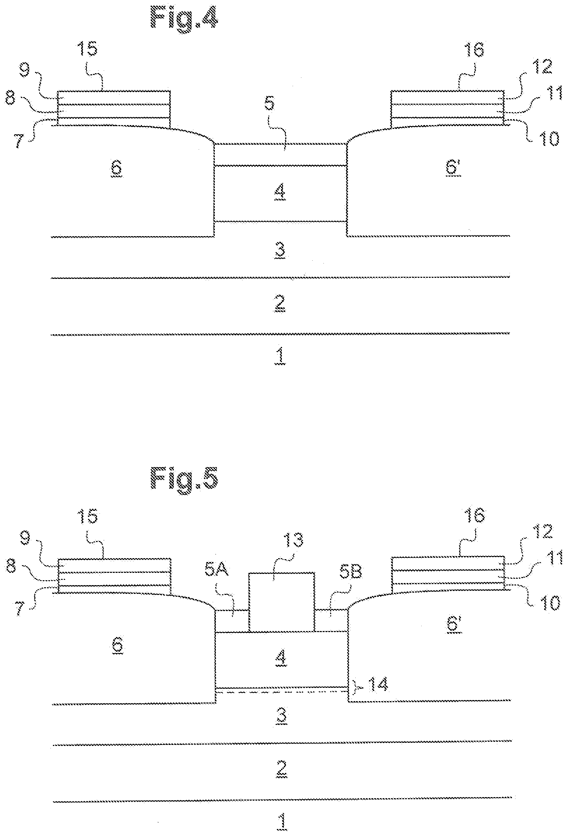

Puis, en référence à la figure 5, on grave une partie de la couche de masquage 5, de sorte qu'il reste seulement deux portions 5A, 5B, de cette couche de masquage SiN, et dans la nouvelle ouverture ainsi définie on dépose un contact de grille métallique 13.

Alternativement, on pourrait bien entendu prévoir de retirer la totalité de la couche de masquage 5 avant le dépôt du contact de grille.

Alternativement encore, il est aussi possible de laisser tout ou en partie de la couche de masquage SiN 5 en place, et de poser l'électrode de grille par dessus.

De façon connue en soi, ce contact de grille peut également être réalisé en plusieurs couches (accrochage, barrière, conduction) non représentées. Par exemple, on pourrait prévoir une couche d'accrochage en Nickel et une couche de conduction en Or.

Le transistor ainsi obtenu peut présenter des parties dopées au Germanium 6, 6', de relativement bonne qualité.

Les matériaux des couches canal 2 et barrière 3 sont choisis de façon à former un gaz bidimentionnel d'électrons, représenté sur la figure 5 par la zone référencée 14. Le dopage au Germanium des couches 6, 6' permet d'obtenir une jonction entre les couches 6, 3, 4 et 6', 3, 4 relativement nette, ce qui contribue à l'amélioration des performances du transistor.

Ce transistor peut permettre de réaliser un circuit MMIC présentant des performances accrues.

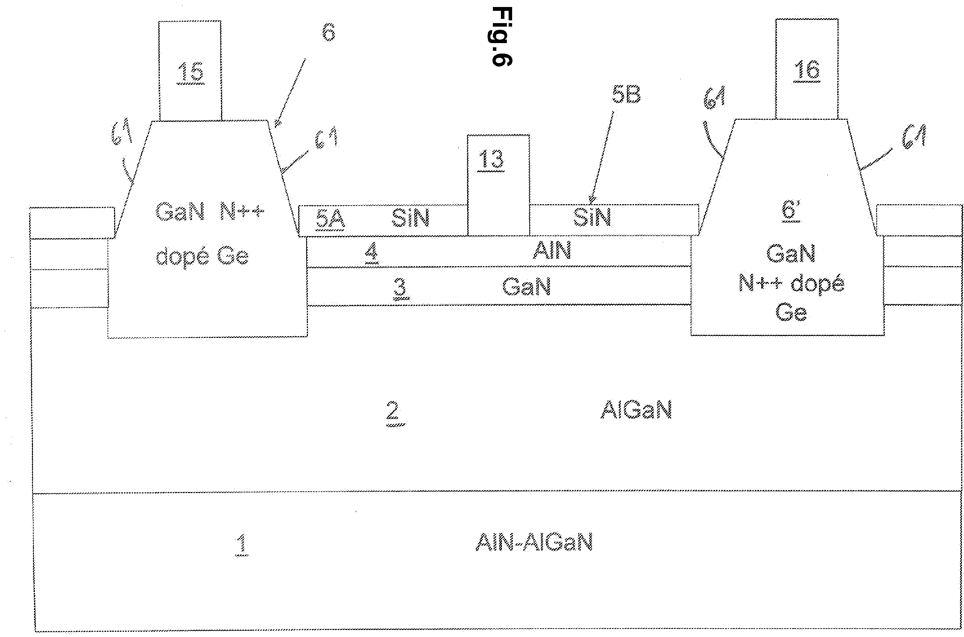

En référence à la figure 6, le transistor HEMT représenté a été obtenu en effectuant une gravure du matériau correspondant aux emplacements définis par la couche de masquage diélectrique correspondant à la référence 5 sur les figures 1 à 4 dans des conditions telles que l'ouverture ainsi définie s'étend jusqu'à la couche tampon 2. Dit autrement, la couche canal 3 est traversée.

Le matériau de croissance épitaxiale est ensuite déposée à haute température.

Comme on l'a expressément représenté sur cette figure, les couches de croissance 6, 6' ainsi obtenues présentent des parois 61 légèrement obliques, en retrait par rapport à la couche de masquage.

Les couches 6, 6' peuvent avoir une épaisseur telle qu'elles s'étendent en hauteur au-delà de la couche de masquage, et ce sans risquer de recouvrir cette couche.

On pourra ainsi choisir de déposer, en début de procédé, une couche de masquage relativement fine.

## Revendications

1. Procédé de fabrication d'un transistor à effet de champ et à hétérojonction comprenant une structure semiconductrice en couches superposées, comprenant
a) prévoir sur une couche substrat (1)
une couche tampon (2) composée d'un matériau semiconducteur à cristal hexagonal Ga_{(1-x-y)}Al₍ₓ₎In_{(y)}N, où x et y sont compris entre 0 inclus et 1 inclus, la somme x+y étant inférieure ou égale à 1,
une couche canal (3) sur la couche tampon, cette couche canal étant composée d'un matériau à cristal hexagonal Ga_{(1-z-w)}Al_{(z)}In_{(w)}N, où z et w sont compris entre 0 inclus et 1 inclus, la somme z+w étant inférieure ou égale à 1, l'un au moins parmi z et w étant différent de x ou y, respectivement,
une couche barrière (4) sur cette couche canal, cette couche barrière étant composée d'un matériau à cristal hexagonal Ga_{(1-z'-w')}Al_{(z')}In_{(w')}N, où z' et w' sont compris entre 0 inclus et 1 inclus, la somme z'+w' étant inférieure ou égale à 1, l'un au moins parmi z' et w' étant différent de z ou w, respectivement,
b) déposer une couche de masquage diélectrique (5) sur la couche barrière,
c) former une ouverture dans la couche de masquage diélectrique et allonger cette ouverture de sorte que la couche barrière présente une épaisseur réduite ou nulle à l'emplacement de l'ouverture,
d) faire croître par épitaxie un matériau semiconducteur à cristal hexagonal (6, 6') Ga_{(1-x'-y')}Al_{(x')}In_{(y')}N dopé au Germanium, où x' et y' sont compris entre 0 inclus et 1 inclus, la somme x'+y' étant inférieure ou égale à 1, à une température suffisamment élevée, comprise entre 700°C et 1200°C, pour que le matériau destiné à former le matériau semiconducteur à cristal hexagonal Ga_{(1-x'-y)}Al_{(x')}In_{(y')}N dopé au Germanium puisse migrer vers une zone de croissance définie par l'ouverture formée dans la couche de masquage, par transport de masse de sorte que ladite étape d) est sélective et que le matériau semiconducteur à cristal hexagonal (6, 6') Ga_{(1-x'-y')}Al_{(x')}In_{(y')}N dopé au Germanium ait une structure cristalline suffisamment définie pour que ses bords latéraux présentent une inclinaison par rapport à la verticale entre 5° et 60° à la hauteur de la couche de masquage et au-delà de celle-ci,
e) déposer une électrode de contact de source ou drain (15, 16) sur le matériau ainsi déposé par épitaxie à l'étape d),
f) déposer une électrode de grille (13) à un emplacement en dehors de la zone de croissance.

2. Procédé selon la revendication 1, dans lequel,
au cours de l'étape d) on met en œuvre une technique d'épitaxie en phase vapeur aux organométalliques.

3. Procédé selon la revendication 1, dans lequel,
au cours de l'étape d) on met en œuvre une technique d'épitaxie par jets moléculaires.

4. Procédé selon l'une quelconque des revendications 1 à 3, dans lequel
le matériau déposé par épitaxie à l'étape d) est un matériau GaN dopé au Germanium.

5. Procédé selon l'une quelconque des revendications 1 à 4, dans lequel,
l'étape e) de dépôt de l'électrode de contact est effectuée sans recuit d'alliage.

6. Procédé selon l'une quelconque des revendications 1 à 5, dans lequel l'étape d) est effectuée à une température strictement supérieure à 960°C et inférieure ou égale à 1150°C.

7. Transistor à effet de champ et à hétérojonction comprenant une structure semiconductrice en couches superposées, comprenant dans l'ordre d'empilage sur une couche substrat (1)
- une couche tampon (2) composée d'un matériau à cristal hexagonal Ga_{(1-x-y)}Al₍ₓ₎In_{(y)}N, où x et y sont compris entre 0 inclus et 1 inclus, la somme x+y étant inférieure ou égale à 1,
- une couche canal (3) sur la couche tampon, cette couche canal étant composée d'un matériau à cristal hexagonal Ga_{(1-z-w})Al_{(z)}In_{(w)}N, où z et w sont compris entre 0 inclus et 1 inclus, la somme z+w étant inférieure ou égale à 1, l'un au moins parmi z et w étant différent de x ou y, respectivement,
- une couche barrière (4) sur cette couche canal, cette couche barrière étant composée d'un matériau à cristal hexagonal Ga_{(1-z'-w')}Al_{(z')}In_{(w')}N, où z' et w' sont compris entre 0 inclus et 1 inclus, la somme z'+w' étant inférieure ou égale à 1, l'un au moins parmi z' et w' étant différent de z ou w, respectivement,
- une couche de matériau épitaxial (6, 6'), située à l'emplacement d'une ouverture dans une couche de masquage diélectrique (5) et dans la couche barrière sur une partie ou sur toute l'épaisseur de cette dernière, ce matériau épitaxial étant à cristal hexagonal et composé de Ga_{(1-x'-y')}Al(_{x')}In_{(y')}N dopé au Germanium, où x' et y' sont compris entre 0 inclus et 1 inclus, la somme x'+y' étant inférieure ou égale à 1, ce matériau épitaxial ayant une structure cristalline suffisamment définie pour que ses bords latéraux présentent une inclinaison par rapport à la verticale entre 5° et 60° à la hauteur de la couche de masquage et au-delà de celle-ci,
- une électrode de contact de source ou drain (15, 16) sur la couche de matériau épitaxial et une électrode de grille (13) à un emplacement extérieur à la zone de croissance.

8. Circuit intégré monolithique hyperfréquences comprenant un transistor selon la revendication 7.

## Patentansprüche

1. Verfahren zur Herstellung eines Feldeffekt- und Heteroübergangstransistors, mit einer Halbleiterstruktur mit übereinanderliegenden Schichten, umfassend
a) Vorsehen, auf einer Substratschicht (1),
eine Pufferschicht (2), die aus einem Halbleitermaterial aus hexagonalem Kristall Ga_{(1-x-y)}A1₍ₓ₎In_{(y)}N besteht, wobei x und y zwischen einschließlich 0 und einschließlich 1 liegen, wobei die Summe x+y kleiner oder gleich 1 ist,
eine Kanalschicht (3) auf der Pufferschicht, wobei diese Kanalschicht aus einem Material aus hexagonalem Kristall Ga_{(1-z-w)}A1_{(z)}In_{(w)}N besteht, wobei z und w zwischen einschließlich 0 und einschließlich 1 liegen, wobei die Summe z+w kleiner oder gleich 1 ist, wobei sich mindestens eines von z und w von x beziehungsweise y unterscheidet,
eine Sperrschicht (4) auf dieser Kanalschicht, wobei diese Sperrschicht aus einem Material aus hexagonalem Kristall Ga_{(1-z'-w')}A1_{(z')}In_{(w')}N besteht, wobei z' und w' zwischen einschließlich 0 und einschließlich 1 liegen, wobei die Summe z'+w' kleiner oder gleich 1 ist, wobei sich mindestens eines von z' und w' von z beziehungsweise w unterscheidet,
b) Aufbringen, auf der Sperrschicht, einer dielektrischen Abschirmungsschicht (5),
c) Bilden einer Öffnung in der dielektrischen Abschirmungsschicht und Verlängern dieser Öffnung, so dass die Sperrschicht an der Stelle der Öffnung eine reduzierte Dicke oder eine von null aufweist,
d) Aufwachsen lassen, durch Epitaxie, eines Halbleitermaterials aus hexagonalem Kristall (6, 6') Ga_{(1-x'-y')}A1_{(x')}In_{(y')}N dotiert mit Germanium, wobei x' und y' zwischen einschließlich 0 und einschließlich 1 liegen, wobei die Summe x'+y' kleiner oder gleich 1 ist, bei einer ausreichend hohen Temperatur, zwischen 700 °C und 1200 °C, so dass das Material, das dazu bestimmt ist, das Halbleitermaterial aus hexagonalem Kristall Ga_{(1-x'-y')}A1_{(x')}In_{(y')}N dotiert mit Germanium zu bilden, durch Stoffübertragung in Richtung einer Wachstumszone wandern kann, die durch die in der Abschirmungsschicht gebildete Öffnung definiert ist, so dass der Schritt d) selektiv ist und dass das Halbleitermaterial aus hexagonalem Kristall (6, 6') Ga_{(1-x'-y')}A1_{(x')}In_{(y')}N dotiert mit Germanium eine kristalline Struktur hat, die ausreichend definiert ist, so dass seine Seitenkanten eine Neigung zwischen 5° und 60° bezogen auf die Vertikale aufweisen, auf Höhe der Abschirmungsschicht und darüber hinaus,
e) Aufbringen einer Source- oder Drain-Kontaktelektrode (15, 16) auf dem Material, das so durch Epitaxie aufgebracht wurde, in Schritt d),
f) Aufbringen einer Gateelektrode (13) an einer Stelle außerhalb der Wachstumszone.

2. Verfahren nach Anspruch 1, wobei,
während Schritt d) eine Technik der metallorganischen Gasphasenepitaxie angewendet wird.

3. Verfahren nach Anspruch 1, wobei,
während Schritt d) eine Technik der Molekularstrahlepitaxie angewendet wird.

4. Verfahren nach einem der Ansprüche 1 bis 3, wobei,
das in Schritt d) durch Epitaxie aufgebrachte Material ein GaN-Material dotiert mit Germanium ist.

5. Verfahren nach einem der Ansprüche 1 bis 4, wobei,
Schritt e) des Aufbringens der Kontaktelektrode ohne Glühen der Legierung durchgeführt wird.

6. Verfahren nach einem der Ansprüche 1 bis 5, wobei Schritt d) bei einer Temperatur durchgeführt wird, die unbedingt höher als 960 °C ist und tiefer oder gleich 1150 °C.

7. Feldeffekt- und Heteroübergangstransistor mit einer Halbleiterstruktur mit übereinanderliegenden Schichten, in der Stapelreihenfolge auf einer Substratschicht (1) umfassend
- eine Pufferschicht (2), die aus einem Material aus hexagonalem Kristall Ga_{(1-x-y)}A1₍ₓ₎In_{(y)}N besteht, wobei x und y zwischen einschließlich 0 und einschließlich 1 liegen, wobei die Summe x+y kleiner oder gleich 1 ist,
- eine Kanalschicht (3) auf der Pufferschicht, wobei diese Kanalschicht aus einem Material aus hexagonalem Kristall Ga_{(1-z-w)}A1_{(z)}In_{(w)}N besteht, wobei z und w zwischen einschließlich 0 und einschließlich 1 liegen, wobei die Summe z+w kleiner oder gleich 1 ist, wobei sich mindestens eines von z und w von x beziehungsweise y unterscheidet,
- eine Sperrschicht (4) auf dieser Kanalschicht, wobei diese Sperrschicht aus einem Material aus hexagonalem Kristall Ga_{(1-z'-w')}A1_{(z')}In_{(w')}N besteht, wobei z' und w' zwischen einschließlich 0 und einschließlich 1 liegen, wobei die Summe z'+w' kleiner oder gleich 1 ist, wobei sich mindestens eines von z' und w' von z beziehungsweise w unterscheidet,
- eine Schicht aus epitaxialem Material (6, 6'), die sich an der Stelle einer Öffnung in einer dielektrischen Abschirmungsschicht (5) befindet und in der Sperrschicht über einen Teil oder über die gesamte Dicke der letzteren, wobei dieses epitaxiale Material aus hexagonalem Kristall ist und aus Ga_{(1-x'-y')}A1_{(x')}In_{(y')}N dotiert mit Germanium besteht, wobei x' und y' zwischen einschließlich 0 und einschließlich 1 liegen, wobei die Summe x'+y' kleiner oder gleich 1 ist, wobei dieses epitaxiale Material eine kristalline Struktur hat, die ausreichend definiert ist, so dass seine Seitenkanten eine Neigung zwischen 5° und 60° bezogen auf die Vertikale aufweisen, auf der Höhe der Abschirmungsschicht und darüber hinaus,
- eine Source- oder Drain-Kontaktelektrode (15, 16) auf der Schicht aus epitaxialem Material und eine Gateelektrode (13) an einer Stelle außenseitig der Wachstumszone liegend.

8. Monolithisch integrierte Höchstfrequenzschaltung, einen Transistor umfassend, nach Anspruch 7.

## Claims

1. Process for fabricating a heterojunction field-effect transistor comprising a semiconductor structure made up of superposed layers, comprising:
a) providing on a substrate layer (1):
a buffer layer (2) composed of a semiconductor material having a hexagonal crystal structure, namely Ga_{(1-x-y)}Al₍ₓ₎In_{(y)}N, where x and y are comprised between 0 inclusive and 1 inclusive, the sum x+y being lower than or equal to 1;
a channel layer (3) on the buffer layer, this channel layer being composed of a material having a hexagonal crystal structure, namely Ga_{(1-z-w})Al_{(z)}In_{(w)}N, where z and w are comprised between 0 inclusive and 1 inclusive, the sum z+w being lower than or equal to 1, at least one of z and w being different from x or y, respectively;
a barrier layer (4) on this channel layer, this barrier layer being composed of a material having a hexagonal crystal structure, namely Ga_{(1-z'-w')}Al_{(z')}In_{(w')}N, where z' and w' are comprised between 0 inclusive and 1 inclusive, the sum z'+w' being lower than or equal to 1, at least one of z' and w' being different from z or w, respectively;
b) depositing a dielectric masking layer (5) on the barrier layer;
c) forming an opening in the dielectric masking layer and extending this opening so that the barrier layer has a reduced or zero thickness at the location of the opening ;
d) growing by epitaxy a semiconductor material (6, 6') having a hexagonal crystal structure, namely Ga_{(1-x'-y')}Al_{(x')}In_{(y')}N, doped with germanium, where x' and y' are comprised between 0 inclusive and 1 inclusive, the sum x'+y' being lower than or equal to 1, at a sufficiently high temperature, comprised between 700°C and 1200°C, so that the material for forming the Germanium-doped Ga_{(1-x'-y')}Al_{(x')}In_{(y')}N hexagonal crystal semiconductor material can migrate to a growth region defined by the opening in the masking layer by mass transport so that said step d) is selective and the Germanium-doped Ga_{(1-x'-y')}Al_{(x')}In_{(y')}N hexagonal crystal semiconductor material (6, 6') has a crystal structure sufficiently defined that its side edges have an inclination relative to the vertical between 5° and 60° at the height of the masking layer and beyond,;
e) depositing a source or drain contact electrode (15, 16) on the material thus deposited by epitaxy in step d); and
f) depositing a gate electrode (13) in a location outside of the growth zone.

2. Process according to Claim 1, in which,
a metalorganic vapour phase epitaxy technique is employed in step d).

3. Process according to Claim 1, in which,
a molecular beam epitaxy technique is employed in step d).

4. Process according to any one of Claims 1 to 3, in which
the material deposited by epitaxy in step d) is germanium-doped GaN.

5. Process according to any one of Claims 1 to 4, in which,
step e) of depositing the contact electrode is carried out without an alloying anneal.

6. Process according to any one of Claims 1 to 5, in which step d) is carried out at a temperature strictly higher than 960°C and lower than or equal to 1150°C.

7. Heterojunction field-effect transistor comprising a semiconductor structure made up of superposed layers, comprising in the stacking order on a substrate layer (1):
- a buffer layer (2) composed of a material having a hexagonal crystal structure, namely Ga_{(1-x-y)}Al₍ₓ₎In_{(y)}N, where x and y are comprised between 0 inclusive and 1 inclusive, the sum x+y being lower than or equal to 1;
- a channel layer (3) on the buffer layer, this channel layer being composed of a material having a hexagonal crystal structure, namely Ga_{(1-z-w)}Al_{(z)}In_{(w)}N, where z and w are comprised between 0 inclusive and 1 inclusive, the sum z+w being lower than or equal to 1, at least one of z and w being different from x or y, respectively; and
- a barrier layer (4) on this channel layer, this barrier layer being composed of a material having a hexagonal crystal structure, namely Ga_{(1-z'-w')}Al_{(z')}In_{(w')}N, where z' and w' are comprised between 0 inclusive and 1 inclusive, the sum z'+w' being lower than or equal to 1, at least one of z' and w' being different from z or w, respectively;
- a layer of epitaxial material (6, 6'), located at an opening in a dielectric masking layer (5) and in the barrier layer over a portion or the entire thickness thereof, said epitaxial material having a hexagonal crystal structure and being composed of Ga_{(1-x'-y'})Al_{(x')}In_{(y')}N doped with germanium, where x' and y' are comprised between 0 inclusive and 1 inclusive, the sum x'+y' being lower than or equal to 1, this epitaxial material having a crystal structure sufficiently defined that its side edges have an inclination relative to the vertical between 5° and 60° at the height of the masking layer and beyond,
- a contact electrode (15, 16) on the layer of growth material and a gate electrode (13) in a location outside of the growth zone.

8. Monolithic microwave integrated circuit comprising a transistor according Claim 7.
